# EUROPEAN PATENT APPLICATION

(11) **EP 4 575 223 A1**
(43) Date of publication of application: **25.06.2025**
(21) Application number: 23218107.3
(22) Date of filing: 19.12.2023
(51) Int. Cl.: F03D 80/00, F03D 80/80

(54) **SYSTEM FOR A WIND TURBINE AND WIND TURBINE**

(71) Applicant: Nordex Energy SE & Co. KG, 22419 Hamburg (DE)
(72) Inventor: KREMER, Jochen, 22419 Hamburg (DE)
(74) Representative: Völkl Siebenson Patentanwälte - Partnerschaft mbB

(57) **Abstract**

According to an embodiment, the system (50) for a wind turbine (100) comprises a first component (1) and a second (2) component. The first component and the second component are arranged rotatable relative to each other with the help of a bearing (3). The system further comprises a first electrical device (10) coupled to the first component and a second electrical device (20) coupled to the second component. Moreover, the system comprises an electrical connection (12) between the first electrical device and the second electrical device as well as a filter element (40, 41) coupled to the electrical connection. The filter element is configured to at least partially attenuate high-frequency electrical signals in the electrical connection.

## Description

The present disclosure relates to a system for a wind turbine and a wind turbine.

Wind turbines are widely known and are used to convert wind energy into electrical energy. Wind turbines comprise rotatable components which have to bear high loads. Damage to these rotatable components or the bearings thereof could lead to a complete failure of the wind turbine.

One object to be achieved is to provide a system for a wind turbine which contributes to an increased lifetime of the wind turbine. A further object to be achieved is to provide a wind turbine with such a system.

First, the system for a wind turbine is specified.

According to an embodiment, the system for a wind turbine comprises a first component and a second component. The first component and the second component are arranged rotatable relative to each other with the help of a bearing. The system further comprises a first electrical device coupled to the first component and a second electrical device coupled to the second component. Moreover, the system comprises an electrical connection between the first electrical device and the second electrical device, as well as a filter element coupled to the electrical connection. The filter element is configured to at least partially attenuate high-frequency electrical signals in the electrical connection.

In large rotating systems, like drivetrains of wind turbines, the rotating components often include electric equipment which need, for example, continuous power supply from a static part of the system through slip ring units or other rotational transfer systems. The power supply from the static part to the rotating part of the drivetrain can be realized, for example, as DC current with one forward conductor and one return conductor, or as AC current in L+N+PE configuration or as an AC three phase system in L1+L2+L3+PE or L1+L2+L3+N+PE configuration. The main part of the current, DC or AC, will then always flow from the static part to the rotating part via the forward conductors and back from the rotating part to the static part via the return conductor or vice versa.

However, in electrical systems with, for example, switching power electronics like switched mode power supplies, inverter-driven power drive systems or large DC systems, there is always a high-frequency content (also called harmonics) on the power supply cables. These high-frequency electrical signals do not follow the usual forward and return conductor paths, as they can flow between the static part and the rotating part on both the forward and the return conductor. Inside the rotating part, the high-frequency signals can transfer from the forward and return conductors via parasitic coupling or filters to grounded components like enclosures, brackets, PE wires and large steel structures inside the rotating part or the static part. From these grounded components, the high-frequency signals flow from the rotating part via the bearings to the static part and back to their source. In the same procedure, the opposite direction is also possible.

When such high-frequency signals flow via a bearing, they can cause damage to the bearing and reduce the lifetime of the bearing. Accordingly, the lifetime of the whole wind turbine could be reduced.

The present invention is, inter alia, based on this recognition. In order to prevent high-frequency signals from flowing through a bearing, a filter element is coupled to the electrical connection which attenuates the high-frequency signals. In this way, the lifetime of the bearing and, accordingly, of the whole wind turbine can be increased.

During operation, the first component of the system may rotate and the second component may be fixed, e.g. to the tower of the wind turbine. Alternatively, the second component may rotate and the first component may be fixed. The rotation between the first and the second component is enabled by the bearing, which may be a plain bearing or a roller bearing or a ball bearing, for example.

The first electrical device is coupled to the first component. This means that the first electrical device is assigned to the first component. For example, the first electrical device is mechanically fixed to the first component. The first electrical device may rotate together with the first component relative to the second component.

Here and in the following, "coupled" means in particular, that there is a mechanical and/or electrical coupling between the coupled elements. The mechanical coupling could be such that the coupled elements are fixed to each other so that the coupled elements are non-movable relative to each other.

The first electrical device may comprise one or more electrical components. Particularly, the first electrical device is a system of electrically connected electrical components.

The second electrical device is coupled to the second component, i.e. is assigned thereto. For example, the second electrical device is mechanically fixed to the second component. It may rotate together with the second component relative to the first component.

Also the second electrical device may comprise one or more electrical components. The second electrical device may be a system of electrically connected electrical components.

The electrical connection electrically connects the first electrical device with the second electrical device. For example, the electrical connection electrically connects at least one electrical component of the first electrical device with at least one electrical component of the second electrical device. The electrical connection may comprise one or more electrical conductors, like wires. For example, the electrical connection comprises at least two or at least three or at least four or at least five electrical conductors. The electrical connection may comprise at least one forward conductor and at least one return conductor. For example, the electrical connection is a DC connection or an AC connection in L+N+PE configuration or an AC 3-phase connection in an L1+L2+L3+PE configuration or in a L1+L2+L3+N+PE configuration.

The filter element is coupled to the electrical connection. This means, in particular, that the filter element is coupled to at least one of the electrical conductors of the electrical connection. The filter element may comprise at least one inductance and/or at least one capacitor. For example, the filter element is an electrical filter element or electronic filter element, respectively. It may then be electrically connected to the electrical connection or the at least one electrical conductor thereof. Alternatively, the filter element may be galvanically separated from the electrical connection, i.e. form the electrical conductors thereof. In this case, the filter element may be an inductive filter element, such as a ring core, absorber core, or snap ferrite.

The filter element is configured to attenuate high-frequency electrical signals in the electrical connection. The system may comprise at least one power electronic component which is the source of the high-frequency electrical signals. For example, the filter element is configured to reduce the amplitudes of the high-frequency electrical signals in the electrical connection by at least 50% or at least 80% or at least 90% or at least 99%. Alternatively, the filter element may completely suppress, i.e. block, the high-frequency signals. High-frequency signals are, for example, signals with a frequency of at least 1 kHz. The filter element may also be configured to reduce or suppress all harmonics of the grid frequency, i.e., signals with a frequency of 100 Hz or more.

According to a further embodiment, the first component is a rotor hub for the wind turbine. The second component is, for example, a nacelle for the wind turbine. The rotor hub may be configured to carry rotor blades of the wind turbine. The nacelle may comprise a control system (e.g. comprising at least one PLC) for controlling the wind turbine. The rotor hub may be coupled to a drivetrain of the wind turbine on one side. Another side of the drivetrain may be coupled to a generator of the wind turbine so that by rotation of the rotor hub, energy can be produced in the generator. The drivetrain comprises, for instance, a rotor shaft and a gearbox. The generator may be coupled to or located in the nacelle.

According to a further embodiment, the electrical connection is fed through a feed-through of the drivetrain.

According to another embodiment, the first component is a nacelle of the wind turbine, and the second component is, for example, the tower of the wind turbine.

According to a further embodiment, at least one of the first electrical device and the second electrical device comprises a power electronic component. This means that either the first electrical device or the second electrical device or both the first and the second electrical device comprise a power electronic component. The power electronic component may be a switching device, like a converter or an inverter or a switched mode power supply or an inverter-driven power drive system or a DC system. The power electronic component may comprise one or more transistors, like IGBTs or MOSFETs. The power electronic component may be directly connected to the electrical connection or may be indirectly connected to the electrical connection via one or more further electrical components.

According to a further embodiment, the first electrical device is or comprises an electrical drive. The electrical drive may be a drive for changing a pitch angle of a rotor blade of the wind turbine. The electrical drive comprises, in particular, an electric motor.

The first electrical device may comprise two or more electrical drives, particularly at least one drive for each rotor blade of the wind turbine. For example, the wind turbine comprises three rotor blades and, accordingly, the first electrical device comprises at least three electrical drives for changing the pitch angles of the rotor blades.

According to a further embodiment, the power electronic component is or comprises a converter and/or an inverter for producing control signals for the electrical drive. Particularly, the first electrical device comprises a control module with such an inverter and/or converter for each of the drives. Power electronic components used for controlling a drive usually produce high-frequency electrical signals.

According to a further embodiment, the second electrical device is or comprises a power supply for supplying the electrical drive with electrical power. The electrical connection may be configured to transfer the electrical power from the power supply to the drive.

According to a further embodiment, the filter element comprises or consists of a soft magnetic material. The soft magnetic material may have an intrinsic coercivity of at most 1000 Am⁻¹. The magnetic material of the filter element may be chosen such that it has a relative magnetic permeability of at least 100 or at least 1000.

According to a further embodiment, the filter element is arranged around at least a portion of the electrical connection. For example, the filter element is arranged around at least one conductor of the electrical connection. For example, the filter element is arranged around all but one of the conductors of the electrical connection. The filter element may then be galvanically separated from the electrical connection. The filter element may completely surround the portion of the electrical connection, particularly it may completely surround the at least one conductor. For example, the filter element is ring-shaped.

According to a further embodiment, the filter element comprises or consists of ferrite and/or a ferromagnetic nanocrystalline alloy. For example, the nanocrystalline alloy is iron-based.

According to a further embodiment, the electrical connection comprises a rotary electrical interface. The rotary electrical interface enables a transfer of an electrical signal, e.g. electrical power, from the second electrical device to the first electrical device or vice versa when the first component rotates relative to the second component. The rotary electrical interface may be a slip ring unit or a galvanic rotational transfer system. The rotary electrical interface could also be configured for a contactless electrical signal transfer.

According to the further embodiment, the power electronic component is coupled either to the first or the second component. The filter element is then coupled to the same component as the power electronic component. Particularly, the filter element is located on the same side of the rotary electrical interface as the power electronic component. This improves the performance of the filter element in terms of attenuating high-frequency electrical signals.

According to a further embodiment, the system comprises a power electronic component coupled to the first component and another power electronic component coupled to the second component. In this case, a filter element may be coupled to the first component and another filter element may be coupled to the second component. For instance, each power electronic component may be assigned a filter element which is arranged on the same side of the rotary electrical interface.

Thus, the system may comprise several power electronic components and/or several filter elements. All features disclosed herein for one power electronic component are also disclosed for the other power electronic component(s). Likewise, all features disclosed herein for one filter element are also disclosed for the other filter element(s). For example, each power electronic component coupled to one of the first and the second component may be assigned a respective filter element coupled to the same one of the first and the second component. Each power electronic component may be assigned a respective filter element on a one-to-one basis, or all power electronic components coupled to the same one of the first and the second component may be assigned to the same filter element.

According to a further embodiment, each wire or electrical conductor, respectively, of the electrical connection which is not grounded is coupled to a filter element. For example, each wire of the electrical connection which is not grounded is surrounded, particularly completely surrounded, by a filter element. Thus, high-frequency signals are attenuated in each wire of the electrical connection which is not grounded.

According to a further embodiment, each wire or electrical conductor, respectively, of the electrical connection which is grounded is not coupled to a or the filter element. Thus, high-frequency signals in a grounded wire of the electrical connection are not attenuated, for example. For instance, the grounded wire/conductor is not surrounded by a filter element.

Indeed, in order to make a filter element work properly, such as a filter element of soft magnetic material, it is advantageous if it attenuates high-frequency signals traveling in one direction. A grounded wire, however, will mostly carry high-frequency signals in the opposite direction. In this way, it may happen that the high-frequency signals in the electrical connection traveling in forward direction are overlaid by the high-frequency signals traveling in backward direction, so that the filter element effectively does not see any high-frequency signal and the filter properties are reduced or lost.

Next, the wind turbine is specified.

According to an embodiment, the wind turbine comprises the system according to any of the embodiments described herein. Accordingly, all features disclosed for the system are also disclosed for the wind turbine and vice versa. The wind turbine may further comprise one or more rotor blades which are connected to the rotor hub. The wind turbine may comprise a control system which is configured to operate the drives of the rotor hub such that the pitch angles of the rotor blade(s) can be adjusted.

Hereinafter, the system for a wind turbine and the wind turbine will be explained in more detail with reference to the drawings on the basis of exemplary embodiments. The accompanying figures are included to provide a further understanding. In the figures, elements of the same structure and/or functionality may be referenced by the same reference signs. It is to be understood that the embodiments shown in the figures are illustrative representations and are not necessarily drawn to scale. Insofar as elements or components correspond to one another in terms of their function in different figures, the description thereof is not repeated for each of the following figures. For the sake of clarity, elements might not appear with corresponding reference symbols in all figures.
Figure 1 shows an exemplary embodiment of the wind turbine,
Figure 2 shows an example of a system for a wind turbine,
Figure 3 shows a first exemplary embodiment of the system for a wind turbine,
Figure 4 shows a second exemplary embodiment of the system for a wind turbine,
Figure 5 shows a third exemplary embodiment of the system for a wind turbine,
Figure 6 shows a further example of a system for a wind turbine, and
Figure 7 shows a fourth exemplary embodiment of the system for a wind turbine.

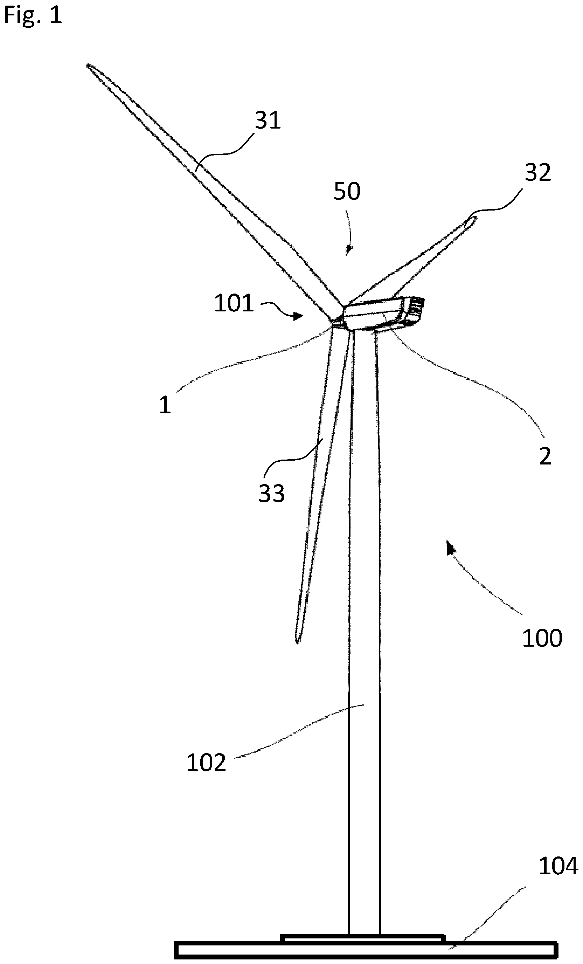

Figure 1 shows a wind turbine 100 which comprises a tower 102. The tower 102 is fixed to the ground by means of a foundation 104. The wind turbine 100 comprises a system 50 comprising a first 1 and a second 2 component. The first component 1 is a rotor hub of a rotor 101 and the second component 2 is a nacelle. The nacelle 2 is rotatably mounted at one end of the tower 102, opposite to the ground. The nacelle 2 comprises, for example, a generator which is coupled to the rotor 101 via a gearbox (not shown). The rotor 101 comprises three rotor blades 31, 32, 33, which are arranged on the rotor hub 1, said rotor hub 1 being connected to a rotor shaft (not shown).

During operation, the rotor 101 is set in rotation by an air flow, for example wind. This rotational movement is transmitted to the generator via a drivetrain comprising, inter alia, the rotor shaft and the gearbox. The generator converts the mechanical energy of the rotor 101 into electrical energy.

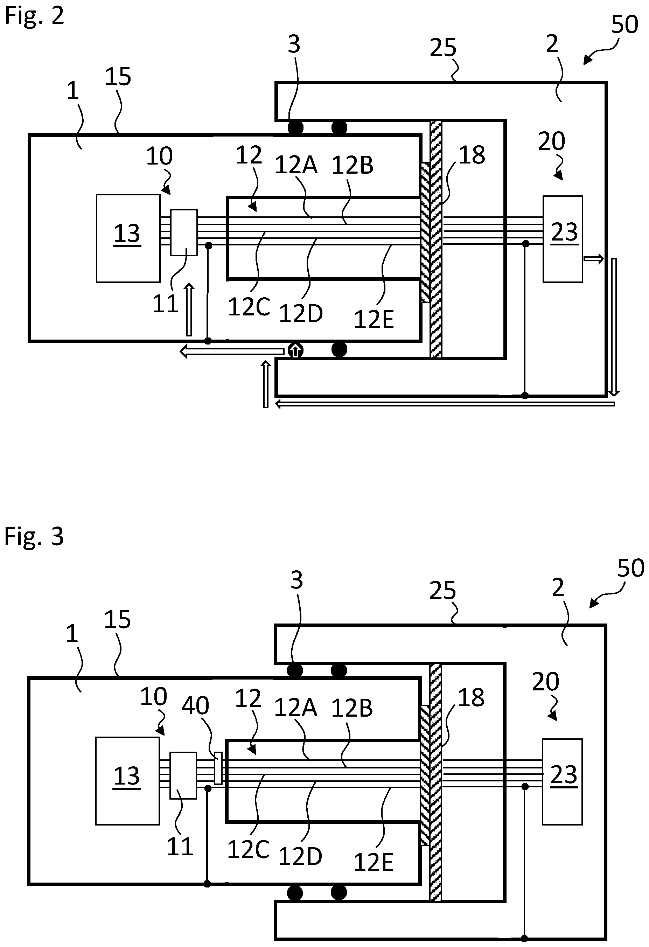

Figure 2 shows a cross-sectional view of an example of the system 50 as it could be used in a wind turbine as shown in figure 1. The system 50 comprises, as already explained, the first component 1, here in the form of the rotor hub, and the second component 2, here in the form of the nacelle. The first component 1 and the second component 2 are arranged rotatable relative to each other with the help of a bearing 3, which is, for example, a roller bearing.

The first component 1 comprises a first electrical device 10, which is coupled to the first component 1. For example, the first electrical device 10 is mechanically fixed to the first component 1 so that it rotates together with the first component 1. The first electrical device 10 comprises an electrical drive 13 with an electric motor for changing the pitch angles of the rotor blades. Additionally, the first electrical device 10 comprises a power electronic component 11, e.g. in the form of a control module having a converter and/or an inverter.

The second component 2 comprises a second electrical device 20 which is coupled to the second component 2. The second electrical device 20 may be mechanically fixed to the second component 2. The second electrical device 20 comprises a power supply 23 for providing the drive 13 of the first component 1 with electrical power.

The first electrical device 10 and the second electrical device 20 are electrically connected to each other via an electrical connection 12. The electrical connection 12 comprises a plurality of wires / conductors 12A, 12B, 12C, 12D, 12E. For example, the wire 12A is an L1 wire, the wire 12B is a L2 wire, the wire 12C is a L3 wire, the wire 12D is an N wire and the wire 12E is a PE wire. The PE wire 12E is grounded. In the region of the first component 1, the wire 12E is grounded to a housing 15 of the first component 1, e.g. the rotor hub housing 15. In the region of the second component 2, the wire 12E is grounded to a housing 25 of the second component 2, e.g. the nacelle housing 25.

In order to enable rotation of the first component 1 relative to the second component 2 while the electrical drive 13 is still provided with electrical power from the power supply 23, the electrical connection 12 comprises a rotary electrical interface 18, for example in the form of a slip ring unit.

Figure 2 shows the system 50 during operation. Due to the power electronic component 11, high-frequency signals are coupled into the electrical connection 12. These high-frequency signals can transfer to the housing 25 of the second component via capacitive coupling. From there, the high frequency signals travel along the housing 25, jump over to the housing 15 of the second component 2 via the bearing 3 and from there they couple back into the power electronic component 11 via capacitive coupling. The path of the high-frequency signals is indicated by the arrows in figure 2.

As high-frequency electrical signals traverse the bearing 3, the bearing 3 can be damaged. This reduces the lifetime of the system 50 and, accordingly, of the whole wind turbine 100.

This problem is solved in the exemplary embodiment of the system 50 of figure 3. The system 50 is essentially the same as the system 50 from figure 2. However, an additional filter element 40 is used, which is coupled to the electrical connection 12. The filter element 40 is, for example, a ring of a soft magnetic material, like ferrite, which completely surrounds the wires 12A, 12B, 12C and 12D, but not the grounded wire 12E. In this way, high-frequency electrical signals in the electrical connection 12 are attenuated by the filter element 40.

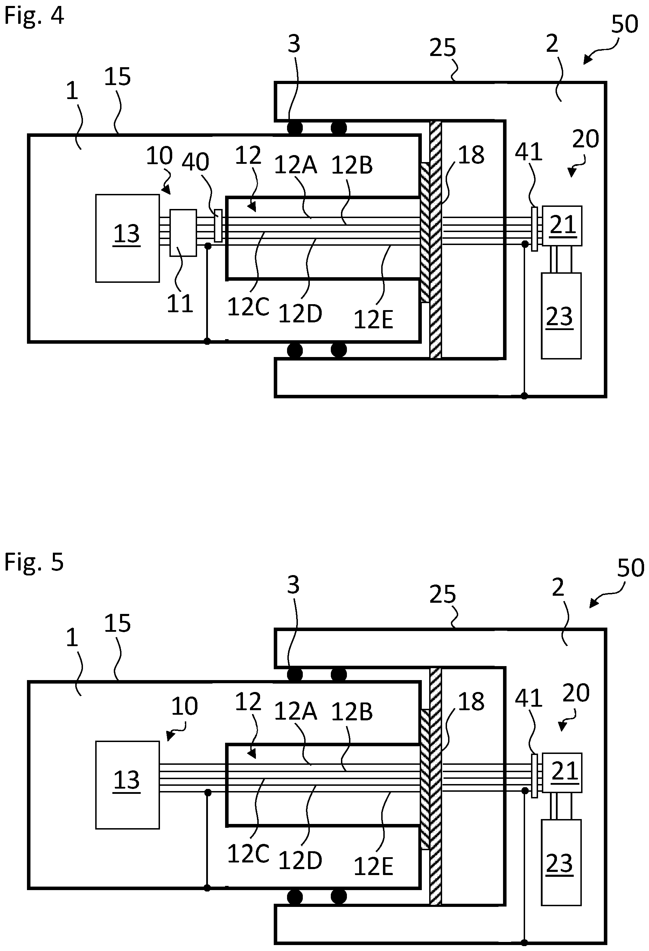

Figure 4 shows a second exemplary embodiment of the system 50. Here, the second electrical device 20 coupled to the second component 2 comprises, besides the power supply 23, a power electronic component 21, for example in the form of an inverter or converter. Additionally, a further filter element 41 is coupled to the electrical connection 12 on the side of the second component 2. Thus, one filter element 40 is assigned to the power electronic component 11 of the first component 1 and another filter element 41 is assigned to the power electronic component 21 of the second component 2. The further filter element 41 may be an electrical filter element 41 which comprises a connection to each of the wires 12A to 12E. In contrast to the filter element 40, the filter element 41 is, for example, not only based on magnetic induction but works electrically or electronically.

Figure 5 shows a third exemplary embodiment of the system 50. Here, only the second component 2 comprises a power electronic component 21. A filter element 41 is coupled to the electrical connection 12 on the side of the second component 2.

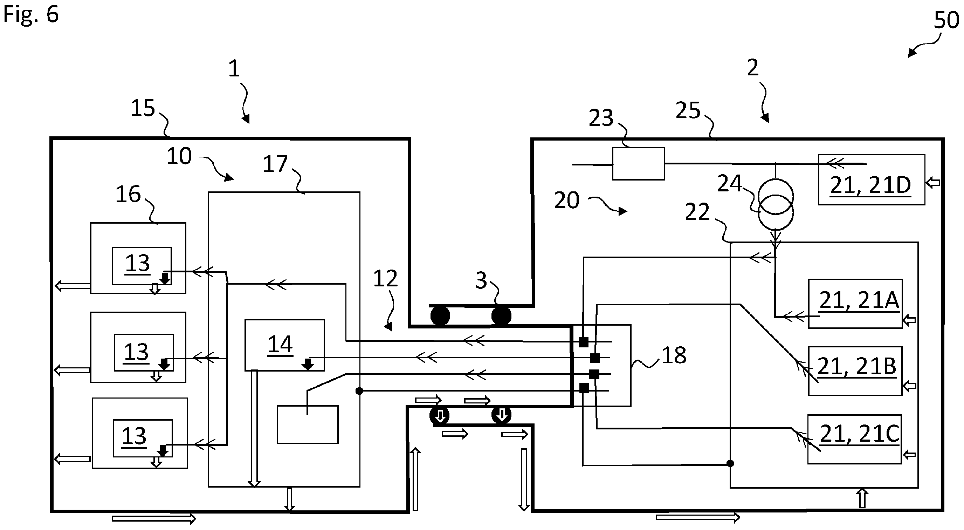

Figure 6 shows another example of a system 50 for a wind turbine. Again, the first component 1 may be the rotor hub and the second component 2 may be the nacelle.

The first component 1 comprises a first electrical device 10 having a 24-Volt power supply 14 as well as three electrical drives 13 with electric motors. Each drive 13 is assigned to one of the rotor blades, for example. The power supply 14 is arranged in a hub distribution cabinet 17. The drives 13 are arranged in boxes 16.

The second component 2 comprises a second electrical device 20 having a yaw drive 21A, a UPS 230-Volt 21B and a 24-Volt power supply / UPS 21C. The three components 21A, 21B, 21C are arranged in a main cabinet 22 and each of them comprises or realizes a power electronic component 21. The second electrical device 20 further comprises a main converter 21D which comprises or realizes a power electronic component 21, as well as a power supply 23 and a transformer 24.

The electrical connection 12 between the first electrical device 10 and the second electrical device 20 comprises four single- or multi wire cables, one of which is grounded to the main cabinet 22 and the hub distribution cabinet 17. As indicated by the double arrows, all the power electronic components 21 induce high-frequency signals into the electrical connection 12. In the first component 1, the high-frequency signals can couple to the boxes 16 and the hub distribution cabinet 17 via parasitic coupling (see full arrows in figure 6) and then travel back to the power electronic components 21 of the second component 2 via the bearing 3 (see open arrows in figure 6). This can cause damage to the bearing 3.

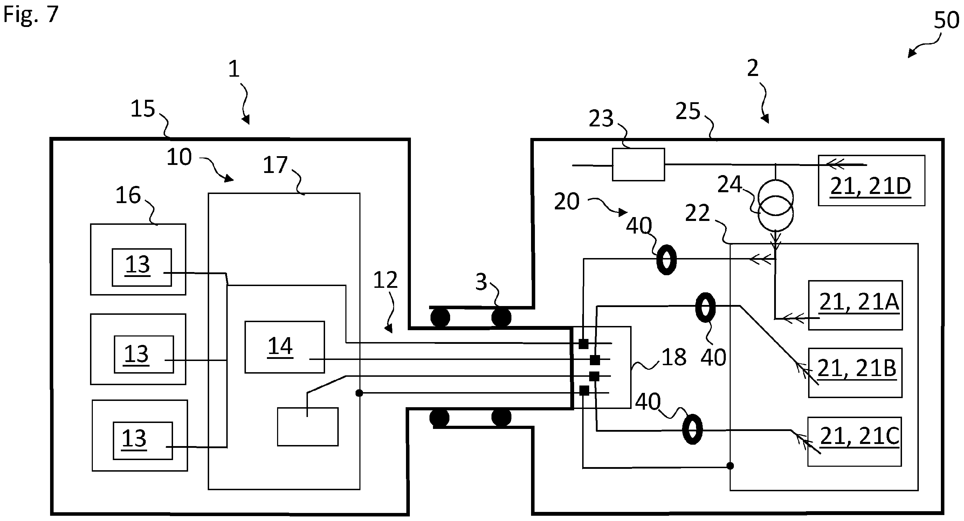

Figure 7 shows essentially the same system as in figure 6, but now filter elements 40 in form of rings of a soft magnetic material are arranged around all of the cable wires of the electrical connection 12 which are not grounded. In this way, the high-frequency signals are attenuated.

The invention described herein is not limited by the description in conjunction with the exemplary embodiments. Rather, the invention comprises any new feature as well as any combination of features, particularly including any combination of features in the patent claims, even if said feature or said combination per se is not explicitly stated in the patent claims or exemplary embodiments.

### Reference sign list:

- 1: first component / rotor hub
- 2: second component / nacelle
- 3: bearing
- 10: first electrical device
- 11: power electronic component
- 12: electrical connection
- 12A: electrical conductor
- 12B: electrical conductor
- 12C: electrical conductor
- 12D: electrical conductor
- 12E: electrical conductor
- 13: electrical drive
- 14: 24-Volt power supply
- 15: housing of the first component
- 16: box
- 17: hub distribution cabinet
- 18: rotary electrical interface
- 20: second electrical device
- 21: power electronic component
- 21A: yaw drive
- 21B: UPS 230-Volt
- 21C: 24-Volt power supply / UPS
- 21D: main converter
- 22: main cabinet
- 23: power supply
- 24: transformer
- 31: rotor blade
- 32: rotor blade
- 33: rotor blade
- 40: filter element
- 41: filter element
- 50: system
- 100: wind turbine
- 101: rotor
- 102: tower
- 104: foundation

## Claims

1. A system (50) for a wind turbine (100) comprising
- a first component (1) and a second component (2), wherein the first component (1) and the second component (2) are arranged rotatable relative to each other with the help of a bearing (3),
- a first electrical device (10) coupled to the first component (1),
- a second electrical device (20) coupled to the second component (2),
- an electrical connection (12) between the first electrical device (10) and the second electrical device (20), and
- a filter element (40, 41) coupled to the electrical connection (12) and configured to at least partially attenuate high-frequency electrical signals in the electrical connection (12).

2. The system (50) according to claim 1, wherein
- the first component (1) is a rotor hub for the wind turbine (100) and the second component (2) is a nacelle for the wind turbine (100),
- the electrical connection (12) is fed through a feed-through of a drivetrain of the wind turbine (100).

3. The system (50) according to claim 1 or 2, wherein
- at least one of the first electrical device (10) and the second electrical device (20) comprises a power electronic component (11, 21),
- the high-frequency electrical signals in the electrical connection result from an operation of the power electronic component (11, 21).

4. The system (50) according to claim 2 and 3, wherein
- the first electrical device (10) is or comprises an electrical drive (13) for changing a pitch angle of a rotor blade (31, 32, 33) of the wind turbine (100),
- the power electronic component (11, 21) is or comprises a converter and/or an inverter for producing high-frequency control signals for the drive (13).

5. The system (50) according to claim 4, wherein
- the second electrical device (20) is or comprises a power supply (23) for supplying the electrical drive (13) with electrical power.

6. The system (50) according to any one of the preceding claims, wherein
- the filter element (40) comprises a soft magnetic material,
- the filter element (40) is arranged around at least a portion of the electrical connection (12).

7. The system (50) according to claim 6, wherein
- the filter element (40) comprises ferrite and/or a ferromagnetic nanocrystalline alloy.

8. The system (50) according to any one of the preceding claims, wherein
- the electrical connection (12) comprises a rotary electrical interface (18) which enables an electrical signal transfer from the second electrical device (20) to the first electrical device (10) or vice versa when the first component (1) rotates relative to the second component (2).

9. The system (50) according to claim 3 or any one of claims 4 to 8 in its dependency on claim 3, wherein
- the power electronic component (11, 21) is coupled either to the first (1) or the second (2) component,
- the filter element (40, 41) is coupled to the same component (1, 2) as the power electronic component (11, 21).

10. The system (50) according to any one of the preceding claims, wherein
- the system (50) comprises a power electronic component (11) coupled to the first component (1) and a power electronic component (21) coupled to the second component (2),
- a filter element (40, 41) is coupled to the first component (1) and another filter element (40, 41) is coupled to the second component (2).

11. The system (50) according to any one of the preceding claims, wherein
- each electrical conductor (12A, 12B, 12C, 12D) of the electrical connection (12) which is not grounded is coupled to a filter element (40).

12. The system (50) according to claim 11, wherein
- each electrical conductor (12E) of the electrical connection (12) which is grounded is not coupled to the filter element (40).

13. Wind turbine (100), comprising the system (50) according to any one of the preceding claims.
